# EUROPEAN PATENT APPLICATION

(11) **EP 3 971 991 A1**
(43) Date of publication of application: **23.03.2022**
(21) Application number: 20196868.2
(22) Date of filing: 18.09.2020
(51) Int. Cl.: H01L 29/778, H01L 29/812, H01L 29/40, H01L 29/16

(54) **STACKED GATE MESFET/HEMT TRANSISTOR ELIMINATING GATE LEAKAGE CURRENT AND PROVIDING NORMALLY OFF TRANSISTOR**

(71) Applicant: III-V Technologies GmbH, Wien (AT)
(72) Inventor: Raissi, Farshid, 1010 WIEN (AT)
(74) Representative: Glawe, Delfs, Moll

(57) **Abstract**

Metal Semiconductor Field Effect Transistor (MESFET) device comprising a layer of semiconductor with two connections for flow of electrical current, being termed source and drain, wherein between the source and drain a metal connection to the semiconductor is created as a Schottky contact , this metal connection being termed gate, wherein a depletion region is formed due to the Schottky contact, the depletion region extending into the semiconductor, wherein an insulating layer (001) is formed over the metal gate of this MESFET and a second metal layer (002) is deposited over the insulator, wherein a gate voltage is applied to the second metal layer while the insulating layer is thick enough to prevent any leakage current from the second to the first metal gate layer.

## Description

This invention relates to eliminating the direct connection between the metal gate of a metal semiconductor field effect transistor (MESFET) and/or high electron mobility transistor (HEMT) to its semiconductor body. In particular this invention provides for elimination of reverse bias leakage current of the gate Schottky junction and also provides for a normally OFF transistor. In order to accomplish these tasks it is suggested to create an insulating layer over the metal gate and deposit a second metal layer over the insulator. The top metal layer provides an isolated connection to the bottom metal gate and affects it electrostatically. Application of voltage to the top metal induces charges in the bottom layer and modulates the depletion region. Both positive and negative voltages can be applied to the gate to either increase or decrease the size of the depletion region. This can be done without the fear of forward biasing the Schottky contact because the insulating layer prevents electrical current from passing through the top metal layer into the semiconductor. As such, normally OFF HEMT and MESFET transistors can be obtained by choosing the work function of the lower metal layer such that the depletion region it creates completely fills the semiconductor layer or by applying a reverse bias voltage to the lower metal layer. The device would be normally off and when a forward bias voltage is applied to the isolated metal the depletion region shrinks, due to the charges induced in the bottom metal, and as a result current starts to flow through the body of the device. Both normally ON and OFF devices can be obtained and can work in tandem to provide for digital circuits. This invention is applicable to all types of MESFET transistors, to which HEMT family belongs, and it also applies to all types of semiconductor materials be it elemental such as Si and Ge or hetero-junction layers of GaAs, GaN or other families of compound semiconductors or 2D materials such as Graphene, etc. The insulating layer created on top of the lower metal layer can be obtained via a number of well-known processes in the literature such as oxidation, nitride alloy creation, incorporation of various compounds or deposition of different insulating layers with various methods.

A Metal Semiconductor Field Effect Transistor (MESFET) device according to the invention comprises a layer of semiconductor with two connections for flow of electrical current, being termed source and drain. Between the source and drain a metal connection to the semiconductor such that a Schottky contact is created, this metal connection being termed gate. A depletion region is formed due to the Schottky contact, the depletion region extending into the semiconductor. An insulating layer is formed over the metal gate of this MESFET and another metal layer is deposited over the insulator, wherein a gate voltage is applied to the second metal layer while the insulating layer is thick enough to prevent any leakage current from the second to the first metal gate layer. This feature can be added to any and all MESFETs of various designs and materials including High Electron Mobility Transistors (HEMT).

In a preferred embodiment the MESFET is a High Electron Mobility Transistors (HEMT).

The insulating layer can be created by allowing the top surface of the first metal layer make an insulating material with a gas inside a vacuum chamber or via chemical processes. In an alternative embodiment the insulating layer is created via deposition of an entirely new material.

The first metal can be comprised of different metal layers itself such that the topmost layer makes a more appropriate surface for insulator creation. The first metal can be chosen such that its work function and physical properties, in conjunction with the semiconductor properties, result in a depletion region width less than the thickness of the semiconductor material. Changes in semiconductor thickness or impurity doping of different types to create such a condition is within the scope of this invention.

It is within the scope of the invention to chose the first metal such that its work function and physical properties, in conjunction with the semiconductor properties, result in a depletion region that covers the whole semiconductor thickness and turns it off. Changes in semiconductor thickness or impurity doping of different types to create such a condition is within the scope of this invention.

The first metal can be connected to an independent bias voltage in order to extend the depletion region all the way through the semiconductor layer and turn the device off under normal circumstances.

A voltage can be applied to the top gate metal such that the Schottky junction is reverse biased and the width of the depletion region increase with such polarity of voltage. This is similar to conventional MESFET operation but without the leakage current. The voltage can be applied to the top gate metal such that the Schottky junction is forward biased and the width of the depletion region decrease with such polarity of the voltage. The inventive device can be used in any high frequency and/or high power combination that regular HEMT transistors are being used with the added features of eliminating gate leakage current or obtaining normally OFF HEMT transistor.

Multiple insulating and metal layers each with or without electric connections to perform various functions fall within the scope of this invention. So does any connection to the first metal layer, for example connecting it to the source to obtain new characteristics.

The semiconductor layer can be a 2D material such as Graphene, etc.

High electron mobility transistors (HEMT) fall under the broad category of junction field effect transistors (JFET). In these devices the depletion region of either a pn or Schottky junction is used to control the area through which current passes from one terminal to another inside a semiconductor material. Those that use Schottky junction for this purpose are called metal semiconductor field effect transistors (MESFET). HEMTs are basically MESFETs whose semiconductor body is made of several layers of varying doping and band gap material that can be grown on top of each other with high quality and precision. One of these layers is intrinsic where electrons can achieve high motilities, not achievable in regular transistors. This high mobility layer is the essence of HEMT transistor operational advantage. The depletion region of the Schottky junction modulates electron density in this layer (C. A. Mead. "Schottky barrier gate field effect transistor". Proceedings of the IEEE, Vol 54, No. 2, pp. 307-308 (1966), T. Mimura et al. :A new field-effect transistor with selectively doped GaAs/n-AlxGa1-xAs hetero-junctions, Jpn. J. Appl. Phys., Vol. 19, No. 5, 1980, pp. L225-L227.)

HEMTs are extensively used in high frequency and high power applications. These range from cellular communications and radar to power converters in renewable energy applications. Most commonly used HEMTs are based on GaAs, GaN and Inp family of materials. This invention applies to all families of materials used in HEMTs as well as MESFETs.

Since HEMTs and MESFETs use the metal side of a Schottky junction as their control or gate terminal, care must be taken to assure the junction remains reverse biased during device's operation. However, in reverse bias there is still leakage current from gate into the semiconductor, which limits the power delivery and operational temperature of the device. To eliminate the leakage current MOSFET type structures have been proposed such as provided in US 2017/0294529A1 "High electron mobility transistor (HEMT) device" by Edward A. Beam, et al or US 2006/0138456 A1 "Insulating gate ALGAN/GAN HEMT" by Primit Parikh, et al. Also MESFET devices are normally ON, which means if there is no voltage applied to the gate, current easily passes through the device. Application of a reverse bias voltage to the gate extends the size of the depletion region and continuously limits the area through which the current can pass. At large enough reverse bias the path is completely closed and device turns off. Transistors that are normally ON are said to operate in enhancement mode. There has been much work concentrated on obtaining normally OFF or depletion mode HEMTs. One method uses an extra layer of semiconductor with an impurity doping opposite to the rest of the semiconductor (Saito, W.; Takada, Y.; Kuraguchi, M.; Tsuda, K.; Omura, I. Recessed-gate structure approach toward normally off high-Voltage AlGaN/GaN HEMT for power electronics applications. IEEE Electron Device Lett. 2006, 53, 356-362).

In this invention our method simultaneously eliminates the leakage current and provides the possibility of obtaining a depletion mode transistor quite easily without changing the MESFET fabrication process or the basis of its operation. Also, this invention provides a new concept for obtaining transistors using two-dimensional materials such as Graphene. Basically the semiconductor can be replaced by any of the two-dimensional materials, which can provide Schottky contact with a metal. In this case the Schottky contact modulates the carrier density inside the two-dimensional material. The source and drain therefore are of the same doping as the material itself, which greatly helps with processing and utility of these materials.

In the following, the invention is described in exemplary fashion on the basis of advantageous embodiments, with reference being made to the attached drawings. In detail:
FIG. 1 shows the configuration of a conventional MESFET.
FIG. 2 shows a MESFET according to the invention.
FIG. 3 shows the depletion mode or normally OFF version of the invention.
FIG.4 shows a different way of obtaining a normally OFF transistor without changing the fist metal gate layer's work function.

A MESFET according to the invention comprises a substrate, which could be an intrinsic semiconductor or an appropriate insulator. There is a semiconductor 04 layer on top of the substrate, which could be an elemental semiconductor such as Si or hetero-junction layers of GaAs or GaN, etc, which include layers for creating a high electron mobility region. Electrical current passes from terminals 01 to 03 through the semiconductor. Gate metallic layer 02 creates the depletion region 05 whose depth can be changed by the gate voltage. To the right the symbol for n channel MESFET is provided. A p channel device would have its gate arrow pointing in the opposite direction coming out of the device.

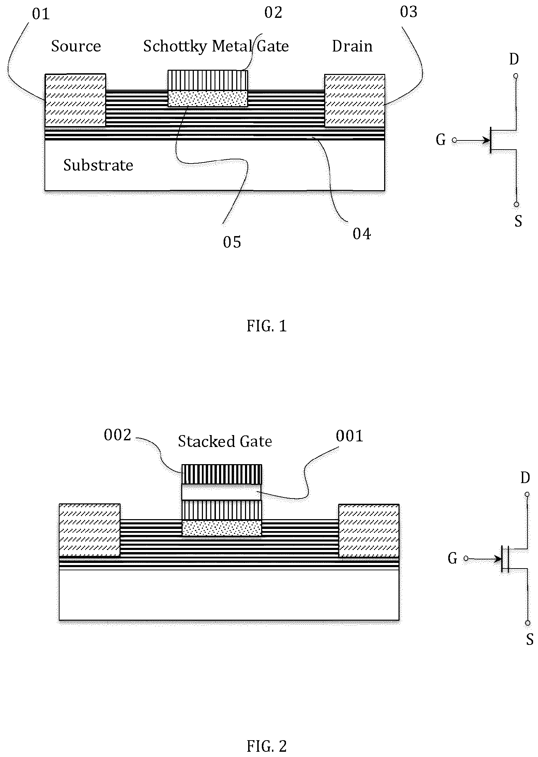

According to FIG. 2 an insulating layer 001 is created over the metal. On top of that another metal layer 002 is deposited. To the right a circuit representation is presented for clarity in which the stacked gate is represented by two separated lines as the gate connection. Again the semiconductor material could be elemental, compound or 2D material.

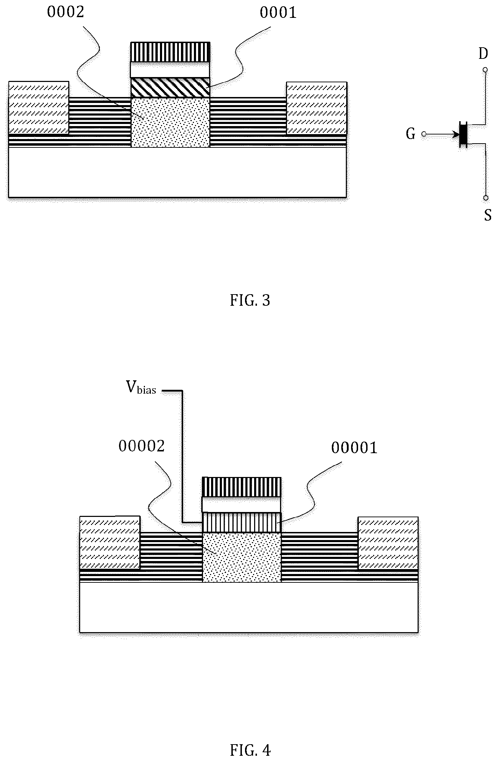

FIG. 3 shows the depletion mode or normally OFF version of the invention. The metal contact 001 has been chosen such that its work function, with respect to the semiconductor properties, provides a depletion region 002 that fills the whole semiconductor thickness. This provides for a normally OFF device. For the circuit representation the area between the two metal gates is blackened. Again for p channel devices the direction of the arrow is reversed at the gate connection.

FIG.4 shows a different way of obtaining a normally OFF transistor without changing the fist metal gate layer's work function. This metal is designated by 00001 and is similar to FIG. 2 and creates a depletion region that does not extend all the way into the semiconductor. However application of a bias voltage extends the depletion region all the way and turns the device off. Now applying voltage to the top metal can turn the device on.

A reverse bias voltage applied to the gate would increase the depth of the depletion region in FIG. 1 and constricts carrier movement (electron or hole currents) from the source to the drain. The same event can occur for the structure of FIG. 2 if the voltage is applied to the top metal. This is so because the charges accumulated on the top metal induce opposite charges on the top surface of the bottom metal layer and like charges at its bottom surface. This charge in turn affects the depth of the depletion region exactly the same way as when the charges are created directly by the gate voltage in regular MESFETs. The important result is that the depletion region width can be controlled without current passing from the gate into the semiconductor. This means that the leakage current from the gate to the semiconductor can be essentially eliminated.

Because no current passes from the top metal into the semiconductor it is possible to apply both polarities of voltage to the Schottky junction without the fear of forward bias current. This means that the depletion region can either be extended or narrowed depending on the polarity of the voltage. In the latter case it allows us to choose the bottom metal layer such that its associated depletion region extends all the way down through the semiconductor reaching the insulating layer at the bottom. This completely impedes flow of carriers from source to the drain. This means that the transistor is normally OFF and is said to operate in depletion mode. By applying a voltage that corresponds to forward biasing the Schottky junction the depletion region is decreased and current starts to flow. The size of the depletion region is a function of the relative difference between the work functions of the metal and semiconductor and its relation to its electron affinity. It is also related to the doping level of the semiconductor material. These can be tailored such that the depletion region extends all the way down. To obtain very fast devices without the need for high mobility transistors one can use Graphene or other 2D materials with very large mobility as the semiconductor material.

## Claims

1. Metal Semiconductor Field Effect Transistor (MESFET) device comprising a layer of semiconductor with two connections for flow of electrical current, being termed source and drain, wherein between the source and drain a metal connection to the semiconductor such that a Schottky contact is created, this metal connection being termed gate, wherein a depletion region is formed due to the Schottky contact, the depletion region extending into the semiconductor, wherein an insulating layer is formed over the metal gate of this MESFET and another metal layer is deposited over the insulator, wherein a gate voltage is applied to the second metal layer while the insulating layer is thick enough to prevent any leakage current from the second to the first metal gate layer.

2. Device according to claim 1 wherein the MESFET is a High Electron Mobility Transistors (HEMT).

3. The device of claim 1 in which the insulating layer is created by allowing the top surface of the first metal layer make an insulating material with a gas inside a vacuum chamber or via chemical processes.

4. The device of claim 1 in which the insulating layer is created via deposition of an entirely new material.

5. The device of claim 1 in which the first metal is comprised of different metal layers itself such that the topmost layer makes an appropriate surface for insulator creation.

6. The device of claim 1 in which the first metal in conjunction with the semiconductor properties is chosen such that a depletion region width is less than the thickness of the semiconductor material.

7. The device of claim 1 in which the first metal in conjunction with the semiconductor properties is chosen such that a depletion region covers the whole semiconductor thickness and turns it off.

8. The device of claim 1 in which the first metal is connected to an independent bias voltage in order to extend the depletion region all the way through the semiconductor layer and turn the device off under normal circumstances.

9. The device of claim 6 with a voltage applied to the top gate metal such that the Schottky junction is reverse biased and the width of the depletion region increase with such polarity of voltage.

10. The device of claim 7 or 8 with a voltage applied to the top gate metal such that the Schottky junction is forward biased and the width of the depletion region decrease with such polarity of the voltage.

11. The device of claims 7, 8 and 9 being used in a high frequency and/or high power combination.

12. The device of claims 1 through 11 with multiple insulating and metal layers each with or without electric connections.

13. The device of claims 1 through 11 in which the semiconductor layer is a 2D material such as Graphene, etc.
